# EUROPEAN PATENT SPECIFICATION

(11) **EP 3 582 197 B1**
(45) Date of publication and mention of the grant of the patent: **21.07.2021**
(21) Application number: 18177085.0
(22) Date of filing: 11.06.2018
(51) Int. Cl.: G08B 13/06, G08B 29/04, H03K 17/95

(54) **AN ENCLOSURE FOR AN ALARM NODE**
GEHÄUSE FÜR EINEN ALARMKNOTEN
ENCEINTE DESTINÉE À UN NOEUD D'ALARME

(43) Date of publication of application: 18.12.2019
(73) Proprietor: Verisure Sàrl, 1290 Versoix (CH)
(72) Inventor: BOOK, Johannes, Trelleborg (SE); MÅRTENSSON, Henrik, 226 52 Lund (SE)
(74) Representative: Hansson Thyresson AB

(56) References cited:
- GB-A- 2 359 649
- US-A- 5 712 621
- US-A1- 2009 140 728
- US-A1- 2016 086 482

## Description

### TECHNICAL FIELD

The present invention relates to an enclosure for an alarm node, comprising a tamper detecting device.

### PRIOR ART

A prior art tamper detecting device configured to detect separation of an enclosure from a wall bracket comprises a mechanical switch that is maintained in a closed position when the enclosure is attached to the wall bracket. When the enclosure is moved away from the wall bracket the mechanical switch is opened and an alarm event is triggered. An example of an alarm system using a tamper detector is disclosed in WO 2007/021729 A2. Another example of an inductive security sensor system which comprises magnetic tamper detection is disclosed in US 2016/086482.

### SUMMARY OF THE INVENTION

In accordance with the invention as defined in independent claim 1 there is provided an enclosure for an alarm node, comprising a tamper detecting device with a frequency setting inductor comprised in a detector, wherein the detector is configured to trigger an alarm event in response to a measured change in inductive properties of the frequency setting inductor, wherein a wall bracket is supporting the enclosure on a mounting surface independently of the wall bracket, wherein the tamper detecting device is configured to detect relative movement between a metal element and the detector, the metal element being a metal element provided in the wall bracket or attached to the mounting surface, wherein the relative movement between the metal element and the detector changes the inductive properties of the frequency setting inductor, wherein the frequency setting inductor is provided as a metal trace winding of a printed circuit board, PCB, wherein a metal trace shielding element is provided on a side of the PCB facing away from the wall bracket.

A device according to embodiments of the invention may be less dependent on narrow tolerances in dimensions between the enclosure and components within the enclosure and an element mounted on a mounting surface. There will be less challenges in mechanical design and no internal stresses due to compression of a mechanical switch. There will also be substantial cost benefits, such as around 30 per cent lower costs, as compared to using a traditional mechanical switch.

Various embodiments of the invention will also be able to detect tampering in situations where the enclosure is mounted on a wall bracket, and the wall bracket is removed from a mounting surface together with the enclosure. This could happen if the wall bracket is not sufficiently fastened to the mounting surface.

Embodiments of the invention can be used in a wireless communications system comprising a plurality of wireless nodes including a first gateway, one or more wireless alarm peripherals and, in some installations, one or more further gateways. The wireless communications system can form part of a home alarm system installation that comprises at least one wireless alarm detector and at least one gateway. The wireless alarm detector will signal alarm events to the gateway. If any of the devices or nodes fail - some action is taken, such as signaling to the gateway and notifying the home owner or triggering a tamper alarm. Signaling of alarm events and tamper alarms can comprise generation of an alarm signal in premises where the alarm system installation is installed and/or forwarding an alarm signal to a remote central monitoring station where further steps for managing the situation can be taken.

A home alarm system installation in general can be any type of wireless systems comprising a plurality peripheral wireless nodes, such as an intruder alarm, and a central unit. Specifically, it can be a security system having a plurality of nodes including wireless detectors, sensitive to the displacement of windows and doors, and to presence or passage of persons and objects, and sensitive to smoke or water leakage, the detectors communicating with a central unit such as a gateway using wireless communication. Security and alarm systems may comprise a control panel. The system may comprise a gateway that is connected to a remote central monitoring station, either by a telephone line or by a wireless telecommunications system such as GSM or other radio frequency systems. The connection can also be through the internet. The control panel can be provided with an input device or be activated and controlled by a control device such as a keypad which can be a wireless remote device.

### BRIEF DESCRIPTION OF THE DRAWINGS

Non-limiting embodiments of the invention will now be described with reference to the figures in which:
- Fig. 1: is a schematic view of an installation of a home alarm system installation,
- Fig. 2: is a schematic diagram showing a typical home alarm system installation including two communication units,
- Fig. 3: is a schematic diagram showing a first embodiment of an enclosure with a tamper detecting device,
- Fig. 4: is a schematic diagram showing a second embodiment of an enclosure with a tamper detecting device,
- Fig. 5: is a schematic perspective view of an enclosure with a tamper detecting device, and
- Fig. 6: is a schematic diagram showing an embodiment of an oscillator that can be used in the tamper detecting device of any of the enclosures shown in Fig. 3 to Fig. 5.

### DETAILED DESCRIPTION

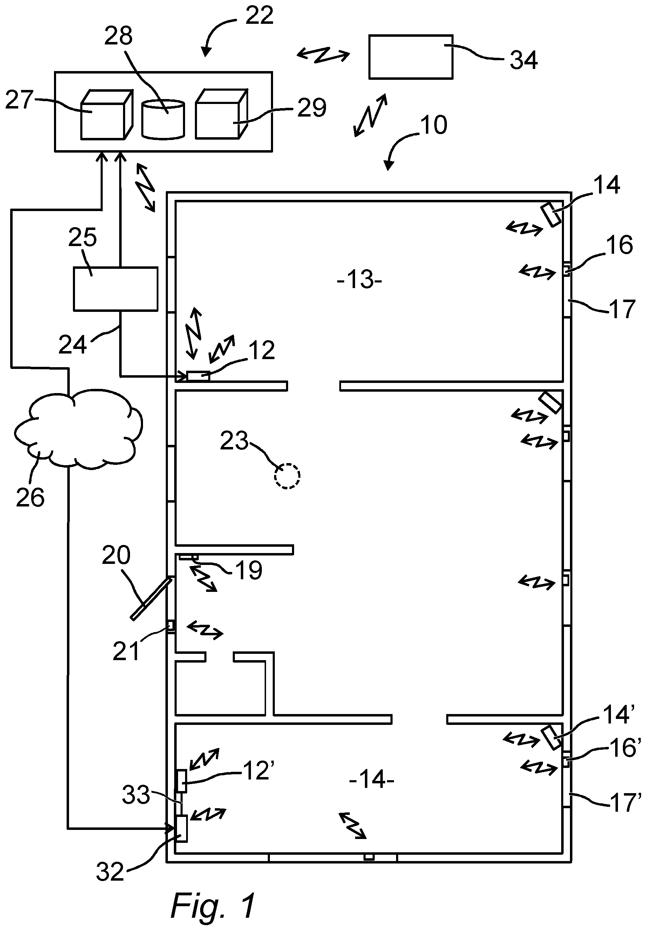

Fig. 1 shows a home alarm system installation in a building 10. The home alarm system installation comprises a plurality of nodes including wireless peripheral devices, a first gateway 12 and a second gateway 12'. The second gateway 12' is mains powered. One wireless peripheral node is a first infrared detector 14 mounted in the corner of a first room 13 close to the ceiling. The first infrared detector 14 has a sensing area that covers the first gateway 12 also disposed in the first room. A camera can be included in the infrared detector 14 or it may form a separate wireless peripheral device. During alarm events, the camera transmits video signals or other images to the gateway 12, 12'. The infrared detector 14 operates in a conventional manner to detect presence and movements of objects emitting infrared radiation.

Another node is a first perimeter alarm detector 16 is mounted at a window 17 in the same room. The perimeter alarm detector can operate in a conventional manner to detect when a door or a window is opened. In various installations the perimeter alarm detector comprises a magnetic sensor that will detect when a magnet attached to the door or window is moved.

A second gateway 12' is arranged in a second room 15 separated from the first room 13 where the first gateway 12 is arranged. A second infrared detector 14' is mounted in the same room as the second gateway 12' to cover the second gateway within its sensing area, and a second perimeter alarm detector 16' is mounted at a second window 17' in the same room. A keypad 19 is mounted close to a front door 20 of the building 10. The keypad 19 is used by a user of the alarm system to arm and to disarm the alarm system. The keypad 19 also is a wireless peripheral node. The front door 20 is covered by a third perimeter alarm detector 21. Another type of wireless peripheral device is a smoke detector 23 mounted in the ceiling of the building. In various installations a plurality of smoke detectors 23 is arranged throughout the building 10 to ensure that fire can be detected at an early stage.

Depending on different circumstances the first gateway 12 and the second gateway 12' are connected to a remote central monitoring station 22 either through a wired connection 24 or through a wireless connection such as GSM or a similar digital cellular network 34. The connection to the remote central monitoring station 22 can also be through the internet 26. In the installation shown in Fig. 1, internet connection is provided through a wireless router 32 that is connected to internet by fiber, cable or Digital Subscriber Line, such as ADSL, or in any similar way. In the installation shown in Fig. 1 the second gateway 12' is connected by wire 33 to the wireless router 32. The wired connection 24 can be part of a public switched telephone network 25. In various installations the remote central monitoring station 22 comprises an interface module 27, a database 28 and a web server 29. The database 28 stores installation and application data relating to the installation including all wireless network nodes and alarm settings.

By placing gateways strategically within a building, it is possible to ensure that all peripheral nodes have an adequate RF link with at least one gateway. As long as each gateway can communicate directly with at least one other gateway and directly or indirectly with all of the other gateways, the installation will function properly. To achieve full redundancy the installation should include enough gateways for every peripheral node to be able to communicate with at least two gateways.

An installation such as the alarm system shown in Fig. 1 holds a large amount of dynamic state information, such as arm state, alarm status, peripheral battery status, etc. in a total system state information dataset. Similar information is stored also in other types of home wireless systems. Each gateway or controller continuously receives inputs from different authenticated sources such as peripheral nodes, a remote central monitoring station (RCMS), adjacent systems, etc. that affects a distributed state of the application or system. In various installations, a second gateway can utilize the RF communication link of another gateway for tunneling messages to an RCMS. For example, if the second gateway up-link to RCMS is very slow or unreachable, or has a higher cost, another gateway up-link can be utilized.

The alarm system can be armed in different ways and into different alarm system states, such as "Disarmed", "Armed Home" and "Armed Away". If the system is set to "Disarmed" it will not alarm to perimeter or interior detectors. Still, fire detectors, other gas detectors, flooding events, power break down events and similar detectors normally will be armed also in the "Disarmed" state. If the alarm system is set to a first armed state referred to as "Armed Home" the alarm system will generate an alarm at the occurrence of a breach of a first group of selected detectors such as perimeter detectors and selected interior detectors, but not to a breach of interior detectors in general. If the system is set to a second armed state referred to as "Armed Away", it will alarm to a breach of the perimeter or interior detectors and normally to all types of detectors.

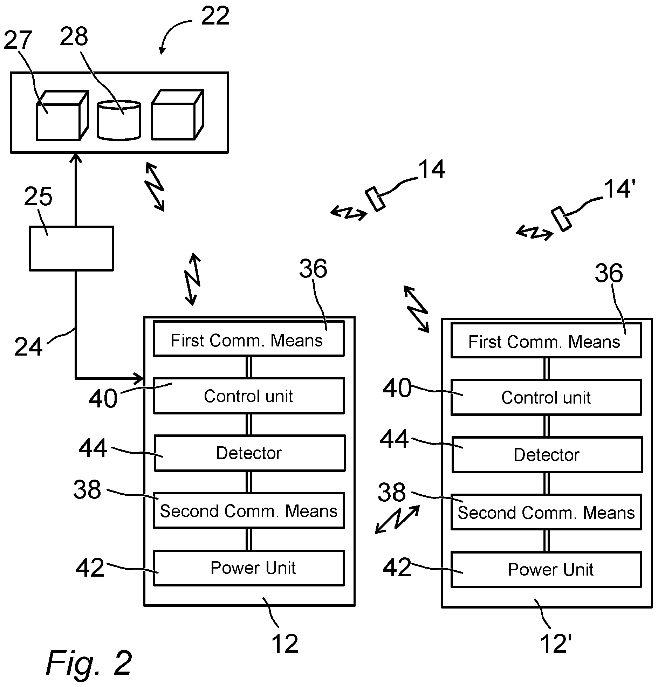

A basic installation is shown in Fig. 2. This installation relates to a home alarm system comprising a first gateway 12, a second gateway 12' and at least one wireless peripheral device, such as an infrared detector 14. The first gateway 12, the second gateway 12' and the infrared detector 14 all communicate using radio communication. At least one gateway is repeatedly communicating with the remote central monitoring station 22 as disclosed above.

The first and the second gateways 12, 12' comprise first communication units 36 and second communication units 38. First communication units 36 is used for communicating with the remote central monitoring station 22 either through a wired connection 24 or through a wireless connection such as GSM or a similar digital cellular network. The connection to the remote central monitoring station 22 can also be through a wired connection, such as a public switched telephone network or the internet. Video and other images will be transmitted to the remote central monitoring station 22.

The second communication units 38 is mainly used for communication within the installation between gateways and between gateways and peripheral nodes. Each gateway is controlled by a control unit 40 and comprises a power unit 42, normally a battery. At least one gateway can be provided with a detector 44 continuously monitoring radio communication received in the gateway. When detector 44 detects intentional or unintentional radio disturbance measures in the radio communication system an alert signal is transferred to control unit 40. An alarm signal then can be generated in the gateway and forwarded to the remote central monitoring station 22 in an appropriate way.

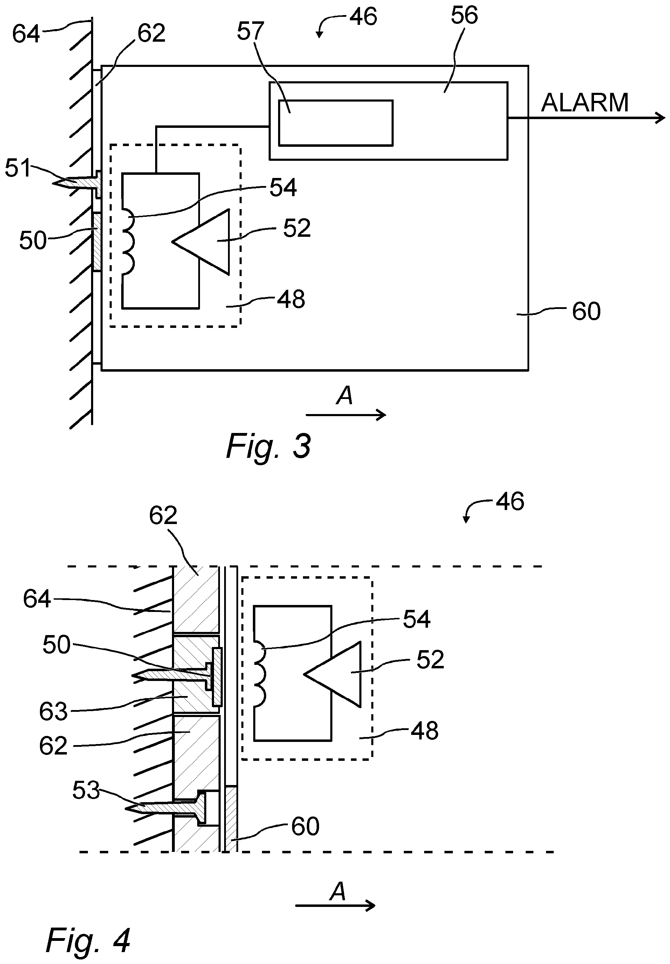

A basic embodiment of an enclosure 60 comprising a tamper detecting device 46 is shown in Fig. 3. The tamper detecting device 46 comprises an inductive detector 48 configured to interact with a metal element 50. The inductive detector 48 comprises an oscillator 52 with a frequency setting inductor 54. The inductive detector 48 is operatively connected to a frequency detecting unit 56. The frequency detecting unit 56 can be implemented in a microcontroller. In various embodiments, the frequency detecting unit 56 comprises a separate frequency counting device 57.

When the wireless peripheral node is mounted on a mounting surface such as a wall or ceiling, the frequency setting inductor 54 is positioned in the vicinity of the metal element 50. In this position, the metal element 50 will interact with the frequency setting inductor 54 and bias its inductive properties. As a result, the frequency of the oscillator will change, should the metal element 50 and the frequency setting inductor 54 be moved in relation to each other. A frequency change over a threshold value will be detected as a tamper attempt, and an alarm will be triggered by sending an alarm signal to a gateway 12; 12'.

Surface mounted nodes, such as gateways, detectors and other peripheral units comprise the enclosure 60 with the tamper detecting device 46 configured to detect separation of the enclosure 60 from a mounting surface 64. In various embodiments, a wall bracket 62 is attached to the mounting surface 64 and the enclosure 60 is attached to the wall bracket 62. The metal element 50 is associated with the wall bracket 62 and the inductive detector 48 is associated with the enclosure 60. As shown in Fig. 3, the metal element 50 is provided in the wall bracket 62 and the inductive detector 48 is arranged in the enclosure 60. In various embodiments, the metal element 50 is a screw 51 used to attach the wall bracket 62 to the mounting surface 64, such as a wall or the ceiling.

In the embodiment shown in Fig. 4, the metal element 50 is provided in a mounting support 63 that is independently attached to the mounting surface 64, such as a wall or ceiling. The enclosure 60 can be attached to the wall bracket 62. One or a plurality of attachment screws 53 are used to attach the wall bracket 62 to the mounting surface 64. If someone pulls the enclosure in accordance with Fig. 3 or Fig. 4 of the mounting surface, the inductive detector 48 will move relative the metal element 50; 51, giving rise to a reliable tamper protection of the enclosure.

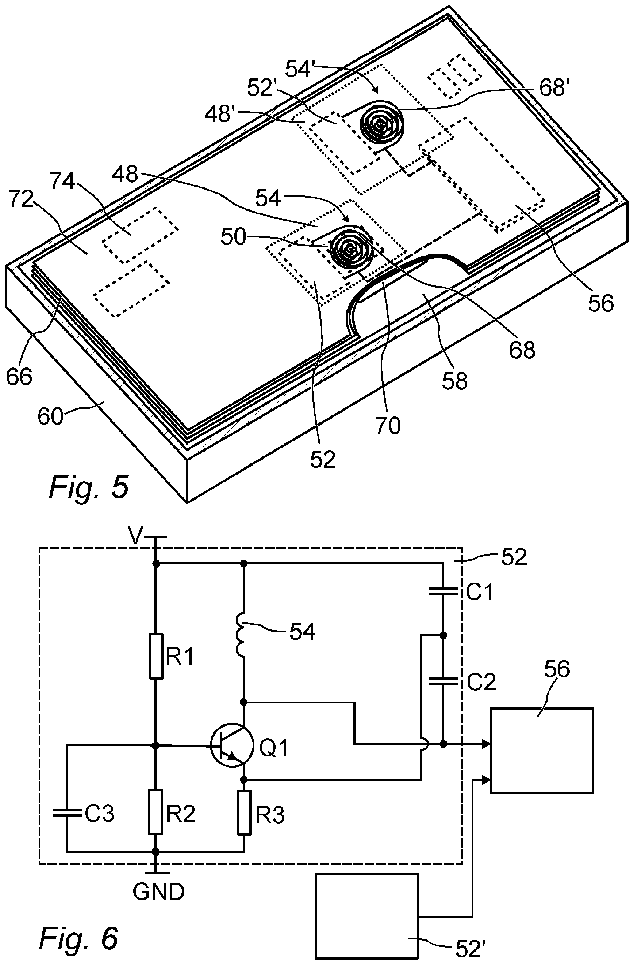

In various embodiments, electronic circuits of the tamper detecting device 46 are mounted or arranged on a printed circuit board 66, PCB, as shown in Fig. 5. In the embodiment shown in Fig. 5, the PCB 66 is a multi-layer board and the frequency setting inductor 54 is a metal trace winding 68 on the PCB 66. In various embodiments, the metal trace winding 68 extends over at least two layers of the PCB 66. The oscillator 52 is also arranged on the PCB 66 as well as the frequency detecting unit 56. A bottom layer 72 of the PCB 66 visible in Fig. 5 is facing the metal element 50, and the metal trace winding 68 in the top layer will be in the vicinity of a metal element 50 when the enclosure 60 with the PCB 66 is properly mounted on the wall 64.

A shielding element 70 is formed on a top layer 58 of the PCB 66. The shielding element 70 is a metal layer on the multi-layer PCB and will decrease effects on the frequency setting inductor 54 of metal objects present or moving outside the enclosure 60 close to the top layer 58. In an example, the frequency setting inductor 54 has a diameter of 7 mm. It will be capable of detecting metal elements at a distance of several millimeters, such as at least 5-10 mm. The metal element preferable is at least 5 mm in diameter. A plurality of other components 74 is also mounted on the top layer 58 of the PCB 66.

The frequency of the oscillator 52 may vary due temperature sensitivity of components used in the oscillator 52. A changing oscillating frequency could be interpreted as a tamper attempt and cause a false alarm. This situation can be avoided by using a reference oscillator 52' and an associated reference frequency setting inductor 54' and by detecting a frequency difference between the oscillators 52, 52'. Preferably, the two oscillators 52, 52' and the two associated frequency setting inductors 54, 54' are identical or have identical properties, at least with regard to impact by temperature variations.

If the oscillating frequency of the oscillators 52; 52' changes due to temperature variations both oscillators 52, 52' be affected the same way and there will be no frequency difference or only a small difference below a threshold value. However, should the inductive detector 48 be moved in relation to the metal element 50 the frequency of the oscillator 52 will change while the frequency of the reference oscillator 52' will remain substantially the same. Thus, there will be a detectable frequency difference between the two oscillators and an alarm will be triggered.

Fig. 6 shows one embodiment of the oscillator 52 comprising a plurality of components. The frequency setting inductor 54 is connected between power V and the collector of a transistor Q1. The transistor Q1 is fed from power V by first resistor R1 and second resistor R2 in series with the first resistor R1, the base of transistor Q1 being connected between the first resistor R1 and the second resistor R2. The first resistor R1 is connected to power V and the second resistor R2 is connected to ground GND. The emitter of transistor Q1 is connected to ground GND through a third resistor R3. A first capacitor C1 and a second capacitor C2 in series are connected in parallel with the frequency setting inductor 54. The emitter of the transistor Q1 is connected to a connection point between first capacitor C1 and second capacitor C2. A third capacitor C3 is connected in parallel with second resistor R2. The frequency of the oscillator 52 will vary as the square root of the inductance of the frequency setting inductor 54. An oscillating signal is output from the collector of the transistor Q1 and fed to the frequency detecting unit 56. In one example, the components are:
R1: 100 kOhm
R2: 100 kOhm
R3: 1 kOhm
C1: 22 nF
C2: 2.2 nF
C3: 1 nF
Q1: BC847C

While certain illustrative embodiments of the invention have been described in particularity, it will be understood that various modifications will be readily apparent to those skilled in the art without departing from the scope of the invention. Accordingly, it is not intended that the scope of the claims appended hereto be limited to the description set forth herein but rather that the claims be construed as encompassing all equivalents of the present invention which are apparent to those skilled in the art to which the invention pertains.

## Claims

1. An enclosure (60) for an alarm node (12; 12'; 14; 14'; 16; 21; 23), comprising a tamper detecting device (46) with a frequency setting inductor (54) comprised in a detector (48), wherein the detector (48) is configured to trigger an alarm event in response to a measured change in inductive properties of the frequency setting inductor (54), wherein a wall bracket (62) is supporting the enclosure (60) on a mounting surface (64), wherein the tamper detecting device (46) is configured to detect relative movement between a metal element (50; 51) and the detector (48), the metal element (50;51) being a metal element (50;51) provided in the wall bracket (62) or attached to the mounting surface (64) independently of the wall bracket (62), wherein the relative movement between the metal element and the detector changes the inductive properties of the frequency setting inductor, wherein the frequency setting inductor (54) is provided as a metal trace winding (68) of a printed circuit board, PCB, (66), wherein a metal trace shielding element (70) is provided on a side of the PCB (66) facing away from the wall bracket (62).

2. The enclosure (60) of claim 1, wherein the detector (48) is inductive and comprises an oscillator (52) with the frequency setting inductor (54), and wherein a frequency detecting unit (56) is operatively connected to the inductive detector (48) and configured to trigger an alarm event when a change of the oscillator frequency larger than a predetermined value has been detected.

3. The enclosure (60) of claim 1, wherein the frequency setting inductor (54) is arranged to change an oscillator frequency depending on location of the frequency setting inductor (54) in relation to the metal element (50; 51).

4. The enclosure (60) of claim 1, wherein the metal element (50; 51) is associated to a wall bracket (62) and the inductive detector (48) is arranged in an enclosure (60).

5. The enclosure (60) of claim 4, wherein the metal element (50; 51) is configured to be mounted to the mounting surface (64) independently of the wall bracket (62).

6. The enclosure (60) of claim 3, wherein the metal element (50; 51) is a screw configured to be screwed into a mounting surface (64).

7. The enclosure (60) of claim 1, wherein the metal trace winding (68) extends over at least two layers of the PCB (66).

8. The enclosure (60) of claim 1, wherein the trace shielding element (70) is provided in a top layer (58) of the PCB (66).

9. The enclosure (60) of claim 1, wherein a reference inductive detector (48') comprises a reference oscillator (52') with a reference frequency setting inductor (54'), a frequency detecting unit (56) is operatively connected to the reference inductive detector (48'), the reference frequency setting inductor (54') is provided as a second metal trace winding (68') of the PCB (66), and wherein the frequency detecting unit (56) is configured to detect a change in frequency of the oscillator (52) in relation to the frequency of the reference oscillator (52').

10. The enclosure (60) of claim 2, wherein the frequency detecting unit (56) comprises a frequency counting device (57).

11. The enclosure (60) of claim 2, wherein the frequency detecting unit (56) comprises a micro controller circuit configured to count pulses generated by the oscillator (52).

12. An alarm node (12; 12'; 14; 14'; 16; 21; 23), comprising an enclosure (60) in accordance with any of the preceding claims.

## Patentansprüche

1. Gehäuse (60) für einen Alarmknoten (12; 12'; 14; 14'; 16; 21; 23), das eine Manipulationserfassungsvorrichtung (46) mit einem Frequenzeinstellungsinduktor (54) umfasst, der in einem Detektor (48) enthalten ist, wobei der Detektor (48) konfiguriert ist, um als Reaktion auf eine gemessene Veränderung von induktiven Eigenschaften des Frequenzeinstellungsinduktors (54) ein Alarmereignis auszulösen, wobei eine Wandhalterung (62) das Gehäuse (60) auf einer Montageoberfläche (64) trägt, wobei die Manipulationserfassungsvorrichtung (46) konfiguriert ist, um eine Relativbewegung zwischen einem Metallelement (50; 51) und dem Detektor (48) zu erfassen, wobei das Metallelement (50; 51) ein Metallelement (50; 51) ist, das in der Wandhalterung (62) bereitgestellt ist oder unabhängig von der Wandhalterung (62) an der Montageoberfläche (64) befestigt ist, wobei die Relativbewegung zwischen dem Metallelement und dem Detektor die induktiven Eigenschaften des Frequenzeinstellungsinduktors verändert, wobei der Frequenzeinstellungsinduktor(54) als eine Metallleiterbahnwicklung (68) einer Leiterplatte (*printed circuit board -* PCB) (66) bereitgestellt ist, wobei ein Metallleiterbahnabschirmungselement (70) auf einer Seite der PCB (66) bereitgestellt ist, die von der Wandhalterung (62) abgewandt ist.

2. Gehäuse (60) nach Anspruch 1, wobei der Detektor (48) induktiv ist und einen Oszillator (52) mit dem Frequenzeinstellungsinduktor (54) umfasst, und wobei eine Frequenzerfassungseinheit (56) mit dem induktiven Detektor (48) wirkverbunden und konfiguriert ist, um ein Alarmereignis auszulösen, wenn eine Veränderung der Oszillatorfrequenz größer als ein zuvor bestimmter Wert erfasst wurde.

3. Gehäuse (60) nach Anspruch 1, wobei der Frequenzeinstellungsinduktor (54) angeordnet ist, um eine Oszillatorfrequenz abhängig von einer Lage des Frequenzeinstellungsinduktors (54) in Bezug auf das Metallelement (50; 51) zu verändern.

4. Gehäuse (60) nach Anspruch 1, wobei das Metallelement (50; 51) mit einer Wandhalterung (62) verknüpft ist und der induktive Detektor (48) in einem Gehäuse (60) angeordnet ist.

5. Gehäuse (60) nach Anspruch 4, wobei das Metallelement (50; 51) konfiguriert ist, um unabhängig von der Wandhalterung (62) an der Montageoberfläche (64) montiert zu werden.

6. Gehäuse (60) nach Anspruch 3, wobei das Metallelement (50; 51) eine Schraube ist, die konfiguriert ist, um in eine Montageoberfläche (64) geschraubt zu werden.

7. Gehäuse (60) nach Anspruch 1, wobei sich die Metallleiterbahnwicklung (68) über wenigstens zwei Schichten der PCB (66) erstreckt.

8. Gehäuse (60) nach Anspruch 1, wobei das Leiterbahnabschirmungselement (70) in einer Oberschicht (58) der PCB (66) bereitgestellt ist.

9. Gehäuse (60) nach Anspruch 1, wobei ein induktiver Referenzdetektor (48') einen Referenzoszillator (52') mit einem Referenzfrequenzeinstellungsinduktor (54') umfasst, eine Frequenzerfassungseinheit (56) mit dem induktiven Referenzdetektor (48') wirkverbunden ist, der Referenzfrequenzeinstellungsinduktor (54') als eine zweite Metallleiterbahnwicklung (68') der PCB (66) bereitgestellt ist, und wobei die Frequenzerfassungseinheit (56) konfiguriert ist, um eine Veränderung der Frequenz des Oszillators (52) in Bezug auf die Frequenz des Referenzoszillators (52') zu erfassen.

10. Gehäuse (60) nach Anspruch 2, wobei die Frequenzerfassungseinheit (56) eine Frequenzzählvorrichtung (57) umfasst.

11. Gehäuse (60) nach Anspruch 2, wobei die Frequenzerfassungseinheit (56) eine Mikrocontrollerschaltung umfasst, die konfiguriert ist, um Impulse zu zählen, die durch den Oszillator (52) erzeugt werden.

12. Alarmknoten (12; 12'; 14; 14'; 16; 21; 23), der ein Gehäuse (60) nach einem der vorhergehenden Ansprüche umfasst.

## Revendications

1. Enceinte (60) destinée à un nœud d'alarme (12 ; 12' ; 14 ; 14' ; 16 ; 21 ; 23), comprenant un dispositif de détection d'effraction (46) doté d'un inducteur de réglage de fréquence (54) comprise dans un détecteur (48), dans laquelle le détecteur (48) est configuré pour déclencher un événement d'alarme en réponse à un changement mesuré des propriétés inductives de l'inducteur de réglage de fréquence (54), dans laquelle un support mural (62) supporte l'enceinte (60) sur une surface de montage (64), dans laquelle le dispositif de détection d'effraction (46) est configuré pour détecter un mouvement relatif entre un élément métallique (50 ; 51) et le détecteur (48), l'élément métallique (50 ; 51) étant un élément métallique (50 ; 51) prévu dans le support mural (62) ou fixé à la surface de montage (64) indépendamment du support mural (62), le mouvement relatif entre l'élément métallique et le détecteur changeant les propriétés inductives de l'inducteur de réglage de fréquence, dans laquelle l'inducteur de réglage de fréquence (54) est prévu sous la forme d'un enroulement de trace métallique (68) d'une carte de circuit imprimé, PCB, (66), dans laquelle un élément de protection contre les traces métalliques (70) est prévu sur un côté de la PCB (66) opposé au support mural (62).

2. Enceinte (60) selon la revendication 1, dans laquelle le détecteur (48) est inductif et comprend un oscillateur (52) doté de l'inducteur de réglage de fréquence (54), et dans laquelle une unité de détection de fréquence (56) est reliée fonctionnellement au détecteur inductif (48) et configuré pour déclencher un événement d'alarme lorsqu'un changement de la fréquence de l'oscillateur plus grand qu'une valeur prédéterminée a été détecté.

3. Enceinte (60) selon la revendication 1, dans laquelle l'inducteur de réglage de fréquence (54) est agencé pour changer une fréquence d'oscillateur en fonction de l'emplacement de l'inducteur de réglage de fréquence (54) par rapport à l'élément métallique (50 ; 51).

4. Enceinte (60) selon la revendication 1, dans laquelle l'élément métallique (50 ; 51) est associé à un support mural (62) et le détecteur inductif (48) est agencé dans une enceinte (60).

5. Enceinte (60) selon la revendication 4, dans laquelle l'élément métallique (50 ; 51) est conçu pour être monté sur la surface de montage (64) indépendamment du support mural (62).

6. Enceinte (60) selon la revendication 3, dans laquelle l'élément métallique (50 ; 51) est une vis conçue pour être vissée dans une surface de montage (64).

7. Enceinte (60) selon la revendication 1, dans laquelle l'enroulement de trace métallique (68) s'étend sur au moins deux couches de la PCB (66).

8. Enceinte (60) selon la revendication 1, dans laquelle l'élément de protection contre les traces (70) est prévu dans une couche supérieure (58) de la PCB (66).

9. Enceinte (60) selon la revendication 1, dans laquelle un détecteur inductif de référence (48') comprend un oscillateur de référence (52') doté d'un inducteur de réglage de fréquence de référence (54'), une unité de détection de fréquence (56) étant reliée fonctionnellement au détecteur inductif de référence (48'), l'inducteur de réglage de fréquence de référence (54') est prévu comme second enroulement de trace métallique (68') de la PCB (66), et dans laquelle l'unité de détection de fréquence (56) est configurée pour détecter un changement de fréquence de l'oscillateur (52) par rapport à la fréquence de l'oscillateur de référence (52').

10. Enceinte (60) selon la revendication 2, dans laquelle l'unité de détection de fréquence (56) comprend un dispositif de comptage de fréquence (57).

11. Enceinte (60) selon la revendication 2, dans laquelle l'unité de détection de fréquence (56) comprend un microcircuit de commande configuré pour compter des impulsions générées par l'oscillateur (52).

12. Nœud d'alarme (12 ; 12' ; 14 ; 14' ; 16 ; 21 ; 23), comprenant une enceinte (60) selon l'une quelconque des revendications précédentes.
